# EUROPEAN PATENT APPLICATION

(11) **EP 4 661 633 A1**
(43) Date of publication of application: **10.12.2025**
(21) Application number: 25177143.2
(22) Date of filing: 16.05.2025
(51) Int. Cl.: H10H 20/831, H10H 20/832

(54) **SEMICONDUCTOR CHIP AND SEMICONDUCTOR WAFER**

(30) Priority: 06.06.2024 CN 202410734105
(71) Applicant: Sino Crystal Semiconductor Co., Ltd., Dongguan Guangdong (CN)
(72) Inventor: Wang, Pu, Dongguan (CN)
(74) Representative: Meyer, Thorsten

(57) **Abstract**

A semiconductor chip includes a chip body, an external electrode, and a buffer electrode formed between the chip body and the external electrode. The buffer electrode includes a tensile stress layer, and the tensile stress layer is formed by alternately stacking multiple metal layers with a large thermal expansion coefficient and multiple metal layers with a small thermal expansion coefficient, to offset at least part of a compressive stress in an epitaxial layer of the chip body. The buffer electrode has a tensile stress system formed by alternately stacking metal layers with a large thermal expansion coefficient and metal layers with a small thermal expansion coefficient, which can offset at least part of the compressive stress within the epitaxial layer of the chip body, thereby reducing the warping degree of the thinned wafer and improving the chip yield.

## Description

### CROSS REFERENCE TO RELATED APPLICATIONS

The present application claims the benefit of Chinese Patent Application No. 202410734105.3 filed on June 6, 2024, the contents of which are incorporated herein by reference in their entirety.

### FIELD OF THE INVENTION

The present invention relates to the field of semiconductors, particularly to a semiconductor chip and a semiconductor wafer.

### BACKGROUND OF THE INVENTION

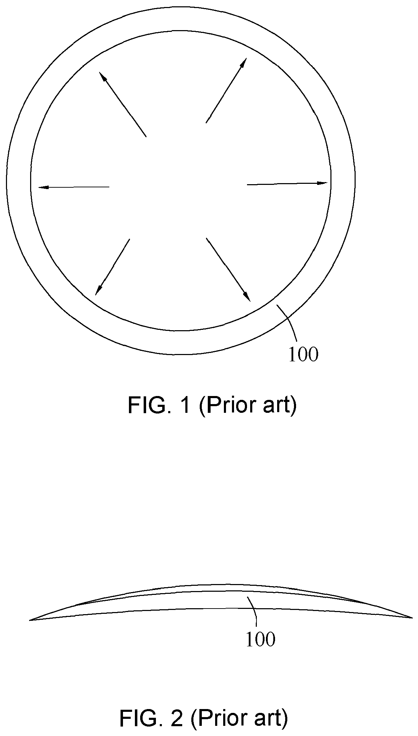

With the continuous advancement of mini-LED display technology, the market demands for mini-LED chips are becoming increasingly diversified and miniaturized. As a result, the mini-LED chips are developing towards smaller sizes and thinner profiles. However, during the epitaxial growth of the GaN epitaxial layer on the substrate, GaN molecules are stacked from the bottom upwards, as shown in FIG. 1. Due to the lattice mismatch with the Al₂O₃ substrate, compressive stress is generated within the GaN material. When the mini-LED wafer is lapped to a thinner thickness, the stress becomes more pronounced, and the wafer is more likely to warp, as shown in FIG. 2. Consequently, the difficulty of laser scribing increases, and the chip yield decreases.

Therefore, there is an urgent need for a semiconductor chip and a semiconductor wafer that can effectively release wafer stress to solve the above problems.

### SUMMARY OF THE INVENTION

The objective of the present invention is to provide a semiconductor chip and a semiconductor wafer that can effectively release wafer stress by incorporating a buffer electrode between the chip body and the external electrode.

To achieve the above objective, the present invention provides a semiconductor chip including a chip body, an external electrode, and a buffer electrode formed between the chip body and the external electrode. The buffer electrode includes a tensile stress layer, and the tensile stress layer is formed by alternately stacking multiple metal layers with a large thermal expansion coefficient and multiple metal layers with a small thermal expansion coefficient, to offset at least part of a compressive stress in an epitaxial layer of the chip body.

Preferably, both the buffer electrode and the external electrode are formed by evaporation.

Preferably, the metal layers with a large thermal expansion coefficient includes tin, aluminum, gold, silver, copper, or nickel; and the metal layers with a small thermal expansion coefficient includes titanium, platinum, or chromium.

Preferably, the tensile stress layer includes 2 to 5 layers of the metal layers with a large thermal expansion coefficient and 2 to 5 layers of the metal layers with a small thermal expansion coefficient, a thickness of each layer of the metal layers with a large thermal expansion coefficient and the metal layers with a small thermal expansion coefficient is 0.05-0.15 µm.

As an optional embodiment, the metal layers with a large thermal expansion coefficient are gold layers of 0.05 µm, and the metal layers with a small thermal expansion coefficient are titanium layers of 0.05 µm. Preferably, the metal layers with a large thermal expansion coefficient are formed by high-temperature evaporation, and the metal layers with a large thermal expansion coefficient are capable to produce a tensile stress effect after being cooled down to room temperature following the high-temperature evaporation. In the tensile stress layer, the alternating stacking of gold and titanium layers forms a regional tensile stress system. The gold layer has a larger thermal expansion coefficient, and after high-temperature evaporation and cooling down to the room temperature, the gold layer is under tensile stress. If the thickness of the gold layer is too large, the tensile stress will relax, causing the gold layer to peel off and reducing the effectiveness. Therefore, the titanium layer, which has a smaller thermal expansion coefficient, is used as a buffer, and then a gold layer is formed. These layers are stacked alternatively, to enhance the tensile stress effect.

As another optional embodiment, the metal layers with a large thermal expansion coefficient are aluminum layers of 0.05 µm, and the metal layers with a small thermal expansion coefficient are titanium layers of 0.05 µm. In this embodiment, aluminum has a larger thermal expansion coefficient, which can generate stronger tensile stress to more effectively offset the compressive stress within the GaN epitaxial layer of the chip body, thereby reducing the warping degree of the thinned wafer

Preferably, the buffer electrode further includes a metal adhesion layer and a conductive protective layer, the metal adhesion layer is formed on the chip body, the tensile stress layer is formed on the metal adhesion layer, and the conductive protective layer is formed on the tensile stress layer.

Specifically, the conductive protective layer includes at least one of platinum, gold, and titanium, with a thickness of 0.3-2 µm.

Specifically, the metal adhesion layer includes at least one of nickel, titanium, and chromium, with a thickness of 0.02-0.08 µm.

More specifically, the metal adhesion layer includes a chromium layer of 0.04 µm.

As an optional embodiment, when the metal layers with a large thermal expansion coefficient are gold layers, the conductive protective layer includes a platinum layer of 0.5 µm formed on the tensile stress layer and a titanium layer of 0.5 µm formed on the platinum layer of 0.5 µm.

As another optional embodiment, when the metal layers with a large thermal expansion coefficient are aluminum layers, the conductive protective layer includes a gold layer of 0.5 µm formed on the tensile stress layer and a platinum layer of 0.5 µm formed on the gold layer of 0.5 µm.

Preferably, the external electrode includes multiple metal layers stacked in sequence, each metal layer has a thickness of 0.05-2 µm, and the metal layers includes at least two of aluminum, titanium, nickel, gold, platinum, and chromium.

Preferably, the chip body is formed on the substrate and includes a GaN epitaxial layer and an ITO (indium tin oxide) layer stacked in sequence. Additionally, a distributed Bragg reflector is formed outside the chip body.

Specifically, the GaN epitaxial layer 20 includes an N-GaN layer, an InGaN quantum well light-emitting layer, and a P-GaN layer, and the thickness of the GaN epitaxial layer 20 is 3-15 µm.

Preferably, the substrate is an Al₂O₃ substrate with a thickness of 400-900 µm.

Preferably, the semiconductor chip is a mini-LED.

Preferably, two buffer electrodes are spaced and arranged on a same side of the semiconductor chip. In such a way, the compressive stress of the epitaxial layer can be buffered at two ends of the semiconductor chip.

The present invention further provides a semiconductor wafer, including a substrate and several semiconductor chips configured on the substrate, and the chip body of the semiconductor chip is formed on the substrate.

Compared with the prior art, the present invention includes a buffer electrode formed between the chip body and the external electrode. The buffer electrode has a tensile stress system formed by alternately stacking metal layers with a large thermal expansion coefficient and metal layers with a small thermal expansion coefficient, which can offset at least part of the compressive stress within the epitaxial layer of the chip body. This reduces the warping degree of the thinned wafer and thereby improves the chip yield. Specifically, when the semiconductor chips are arranged on the substrate to form grains, each grain is equipped with this buffer electrode. This can offset at least part of the compressive stress within the epitaxial layer of the grain, reduce the stretching effect of the epitaxial surface within the epitaxial layer, decrease the warping degree of the thinned wafer, and enhance the chip yield.

### BRIEF DESCRIPTION OF THE DRAWINGS

The accompanying drawings facilitate an understanding of the various embodiments of this invention. In such drawings:
FIG. 1 is a schematic diagram showing the stress generated in the epitaxial layer of the conventional wafer;
FIG. 2 is a side view of the conventional wafer showing the warping after the substrate has been thinned;
FIG. 3 is a structural diagram of the semiconductor chip according to Embodiment 1 of the present invention;
FIG. 4 is a structural diagram of the external electrode in the present invention;
FIG. 5 is a structural diagram of the buffer electrode according to Embodiment 1 of the present invention;
FIG. 6 is a structural diagram of the semiconductor chip according to Embodiment 2 of the present invention; and
FIG. 7 is a structural diagram of the buffer electrode in according to the Embodiment 2 of the present invention.

### DETAILED DESCRIPTION OF ILLUSTRATED EMBODIMENTS

To elaborate on the technical content, structural features, and the effects achieved, the present invention will be described in detail below with reference to the accompanying drawings and preferred embodiments.

The present invention discloses a semiconductor wafer 100, which includes a substrate 10 and several semiconductor chips 200 configured on the substrate 10. The chip body 2 of the semiconductor chip 200 is formed on the substrate 10.

Specifically, the substrate 10 is an Al₂O₃ substrate with a thickness of 400-900 µm. However, the substrate 10 is not limited to the Al₂O₃ substrate.

FIG. 1 is a schematic diagram showing the stress generated in the epitaxial layer on the conventional wafer 100 and FIG. 2 is a side view of the wafer showing the warping after the substrate has been thinned. In order to reduce the stretching effect of the epitaxial surface of the epitaxial layer, decrease the warping of the thinned wafer, and improve the chip yield, the present invention introduces a buffer electrode 50 between the chip body 2 of the semiconductor chip 200 and the external electrode 40 to offset at least part of the compressive stress within the epitaxial layer of the grain. In this case, the semiconductor chip 200 is a mini-LED, and the epitaxial layer is a GaN epitaxial layer.

### Embodiment 1

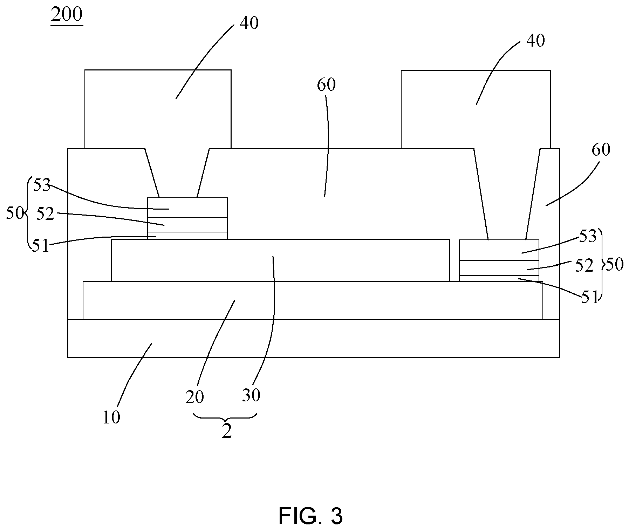

Referring to FIG. 3, the semiconductor chip 200 includes a chip body 2, an external electrode 40, and a buffer electrode 50 formed between the chip body 2 and the external electrode 40.

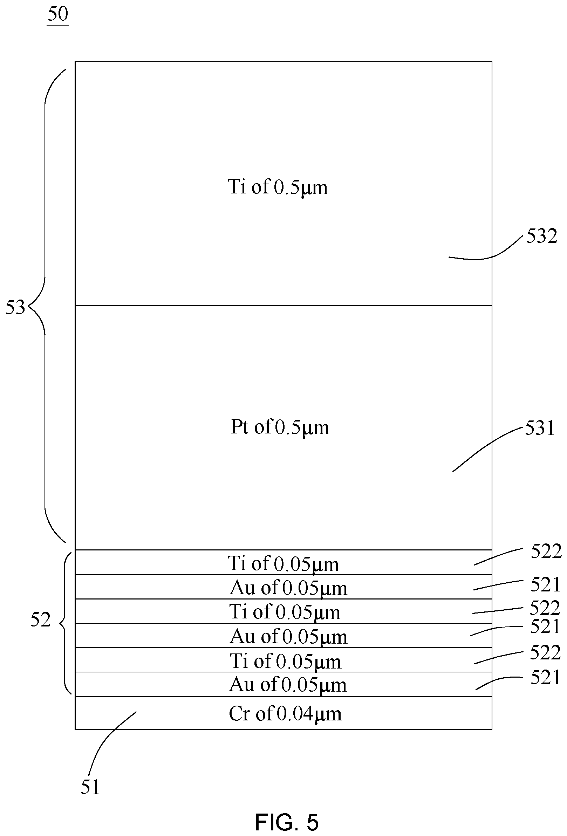

Referring to FIG. 5, the buffer electrode 50 includes a metal adhesion layer 51 formed on the chip body 2, a tensile stress layer 52 formed on the metal adhesion layer 51, and a conductive protective layer 53 formed on the tensile stress layer 52. The tensile stress layer 52 is formed by alternately stacking multiple metal layers 521 with a large thermal expansion coefficient and multiple metal layers 522 with a small thermal expansion coefficient. Of course, the tensile stress layer 52 of the buffer electrode 50 can be directly formed on the chip body 2 without the metal adhesion layer 51, and the external electrode 40 can also be directly formed on the outer side of the tensile stress layer 52 without the conductive protective layer 53.

Referring to FIG. 3, the chip body 2 is formed on the substrate 10 and includes a GaN epitaxial layer 20 and an ITO (indium tin oxide) layer 30 stacked in sequence. Additionally, a distributed Bragg reflector 60 is formed outside the chip body 2. The GaN epitaxial layer 20 includes an N-GaN layer, an InGaN quantum well light-emitting layer, and a P-GaN layer, and the thickness of the GaN epitaxial layer 20 is 3-15 µm. Of course, the structure of the chip body 2 is not limited to this.

Both the buffer electrode 50 and the external electrode 40 are formed by evaporation.

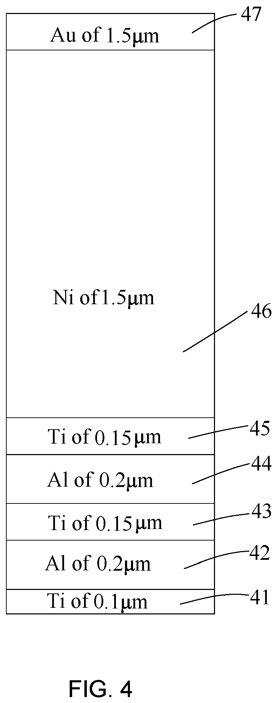

The external electrode 40 includes multiple metal layers stacked in sequence, with each metal layer having a thickness of 0.05-2 µm. Referring to FIG. 4, the external electrode 40 includes a titanium (Ti) layer 41 of 0.1 µm, an aluminum (Al) layer 42 of 0.2 µm, a titanium layer 43 of 0.15 µm, an aluminum layer 44 of 0.2 µm, a titanium layer 45 of 0.15 µm, a nickel (Ni) layer 46 of 1.5 µm, and a gold (Au) layer 47 of 0.15 µm stacked together. The metal layers of the external electrode 40 include at least two of aluminum (Al), titanium (Ti), nickel (Ni), gold (Au), platinum (Pt), and chromium (Cr).

Referring to FIG. 5, in the buffer electrode 50, the metal adhesion layer 51 includes at least one of nickel, titanium, and chromium, with a thickness of 0.02-0.08 µm. In this embodiment, as shown in FIG. 5, the metal adhesion layer 51 includes a chromium layer of 0.04 µm.

In this embodiment, the tensile stress layer 52 includes 2 to 5 metal layers 521 with a large thermal expansion coefficient and 2 to 5 metal layers 522 with a small thermal expansion coefficient, with each metal layer 521 with a large thermal expansion coefficient and each metal layer 522 with a small thermal expansion coefficient having a thickness of 0.05-0.15 µm. The metal layers 521 with a large thermal expansion coefficient include tin, aluminum, gold, silver, copper, or nickel, etc.; the metal layers 522 with a small thermal expansion coefficient include titanium, platinum, or chromium, etc.

Referring to FIG. 5, the metal layers 521 with a large thermal expansion coefficient are gold layers of 0.05 µm, and the metal layers 522 with a small thermal expansion coefficient are titanium layers of 0.05 µm. In this embodiment, three metal layers 521 with a large thermal expansion coefficient and three metal layers 522 with a small thermal expansion coefficient are arranged.

The metal layers 521 with a large thermal expansion coefficient is formed by high-temperature evaporation, and metal layers 521 can produce a tensile stress effect after being cooled down to room temperature following high-temperature evaporation. In the tensile stress layer 52, the alternating stacking of gold and titanium layers forms a regional tensile stress system. The gold layer has a larger thermal expansion coefficient, and after high-temperature evaporation and cooling down to the room temperature, the gold layer is under tensile stress. If the thickness of the gold layer is too large, the tensile stress will relax, causing the gold layer to peel off and reducing the effectiveness. Therefore, the titanium layer, which has a smaller thermal expansion coefficient, is used as a buffer, and then a gold layer is formed. These layers are stacked alternatively, to enhance the tensile stress effect.

The conductive protective layer 53 includes at least one of platinum, gold, and titanium, with a thickness of 0.3-2 µm. Referring to FIG. 5, the conductive protective layer 53 includes a platinum layer 531 of 0.5 µm formed on the tensile stress layer 52 and a titanium layer 532 of 0.5 µm formed on the platinum layer 531 of 0.5 µm.

The distributed Bragg reflector 60 is formed by alternately stacking silicon oxide layers and titanium oxide layers, with a total of 12-68 layers, each layer having a thickness of 0.08-0.15 µm. In this embodiment, the sum of the silicon oxide layers and the titanium oxide layers in the Bragg reflector is 33 layers, with a total thickness of 4 µm.

### Embodiment 2

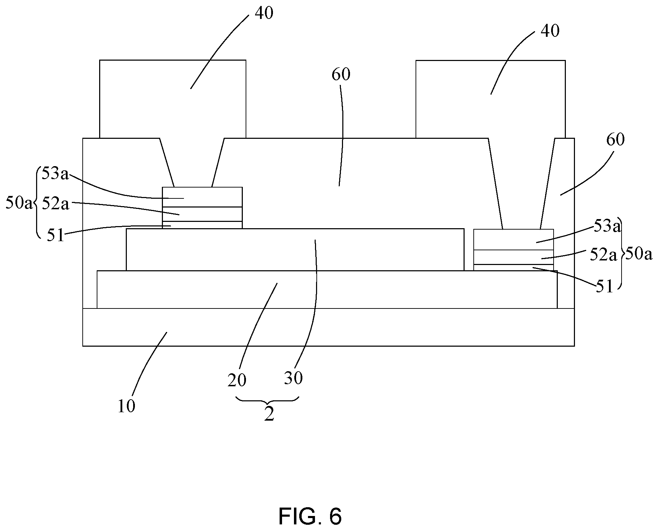

Referring to FIG. 6, the semiconductor chip 200 includes a chip body 2, an external electrode 40, and a buffer electrode 50a formed between the chip body 2 and the external electrode 40.

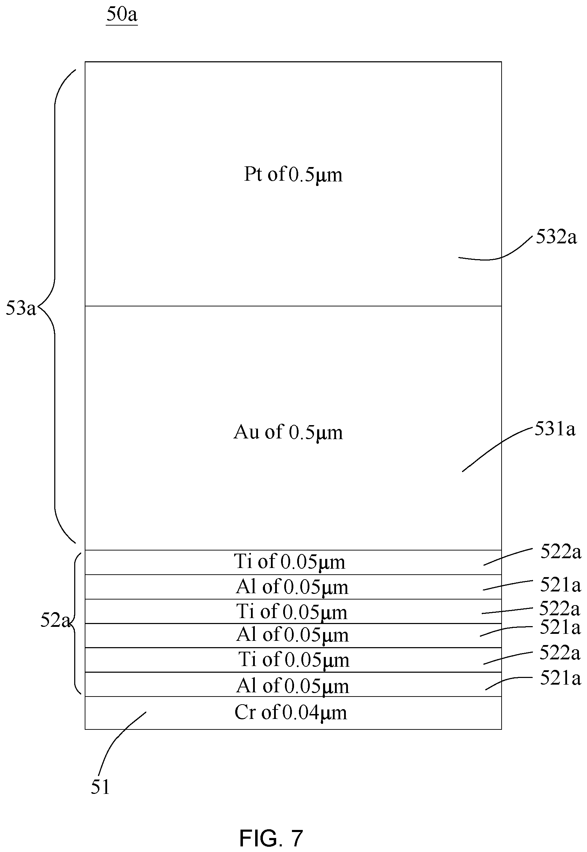

Referring to FIG. 7, the buffer electrode 50a includes a metal adhesion layer 51 formed on the chip body 2, a tensile stress layer 52a formed on the metal adhesion layer 51, and a conductive protective layer 53a formed on the tensile stress layer 52a. The tensile stress layer 52a includes multiple metal layers 521a with a large thermal expansion coefficient and multiple metal layers 522a with a small thermal expansion coefficient 522a stacked alternately.

Referring to FIG. 6, the chip body 2 is formed on the substrate 10 and includes a GaN epitaxial layer 20 and an indium tin oxide (ITO) layer 30 stacked in sequence. Additionally, a distributed Bragg reflector 60 is formed outside the chip body 2. The GaN epitaxial layer 20 includes an N-GaN layer, an InGaN quantum well light-emitting layer, and a P-GaN layer, and the GaN epitaxial layer 20 has a thickness of 3-15 µm.

Both the buffer electrode 50a and the external electrode 40 are formed by evaporation.

The external electrode 40 includes multiple metal layers stacked in sequence, with each metal layer having a thickness of 0.05-2 µm. Referring to FIG. 4, the external electrode 40 includes a titanium layer 41 of 0.1 µm, an aluminum layer 42 of 0.2 µm, a titanium layer 43 of 0.15 µm, an aluminum layer 44 of 0.2 µm, a titanium layer 45 of 0.15 µm, a nickel layer 46 of 1.5 µm, and a gold layer 47 of 0.15 µm stacked together.

Referring to FIG. 7, in the buffer electrode 50a, the metal adhesion layer 51 includes at least one of nickel, titanium, and chromium, with a thickness of 0.02-0.08 µm. In this embodiment, the metal adhesion layer 51 includes a chromium layer of 0.04 µm.

In this embodiment, the tensile stress layer 52a includes 2 to 5 metal layers 521a with a large thermal expansion coefficient and 2 to 5 metal layers 522a with a small thermal expansion coefficient, each layer with a thickness of 0.05-0.15 µm. The metal layers 521a with a large thermal expansion coefficient include tin, aluminum, gold, silver, copper, or nickel, while the metal layers 522a with a small thermal expansion coefficient include titanium, platinum, or chromium.

Referring to FIG. 7, the metal layers 521a with a large thermal expansion coefficient are aluminum layers of 0.05 µm, and the metal layers 522a with a small thermal expansion coefficient are titanium layer of 0.05 µm. In this embodiment, aluminum has a larger thermal expansion coefficient, which can generate stronger tensile stress to more effectively offset the compressive stress within the GaN epitaxial layer 20 of the chip body 2, thereby reducing the warping degree of the thinned wafer 100. In this embodiment, there are three metal layers 521a with a large thermal expansion coefficient and three metal layers 522a with a small thermal expansion coefficient.

The conductive protective layer 53a includes at least one of platinum, gold, and titanium, with a thickness of 0.3-2 µm. Referring to FIG. 7, the conductive protective layer 53a includes a gold layer 531a of 0.5 µm formed on the tensile stress layer 52a and a platinum layer 532a of 0.5 µm formed on the gold layer 531a of 0.5 µm.

The foregoing description of the present invention has been presented for purposes of illustration and description. It is not intended to be exhaustive or to limit the invention to the precise form disclosed, and obviously many modifications and variations are possible in light of the above teaching. Such modifications and variations that may be apparent to those skilled in the art are intended to be included within the scope of this invention as defined by the accompanying claims.

## Claims

1. A semiconductor chip, comprising a chip body and an external electrode, wherein a buffer electrode is formed between the chip body and the external electrode, the buffer electrode comprises a tensile stress layer, the tensile stress layer is formed by alternately stacking multiple metal layers with a large thermal expansion coefficient and multiple metal layers with a small thermal expansion coefficient, to offset at least part of a compressive stress in an epitaxial layer of the chip body.

2. The semiconductor chip according to claim 1, wherein the metal layers with a large thermal expansion coefficient comprises tin, aluminum, gold, silver, copper, or nickel; and the metal layers with a small thermal expansion coefficient comprises titanium, platinum, or chromium.

3. The semiconductor chip according to claim 1, wherein the tensile stress layer comprises 2 to 5 layers of the metal layers with a large thermal expansion coefficient and 2 to 5 layers of the metal layers with a small thermal expansion coefficient, a thickness of each layer of the metal layers with a large thermal expansion coefficient and the metal layers with a small thermal expansion coefficient is 0.05-0.15 µm.

4. The semiconductor chip according to claim 3, wherein the metal layers with a large thermal expansion coefficient are gold layers of 0.05 µm, and the metal layers with a small thermal expansion coefficient are titanium layers of 0.05 µm; or,
the metal layers with a large thermal expansion coefficient are aluminum layers of 0.05 µm, and the metal layers with a small thermal expansion coefficient are titanium layers of 0.05 µm.

5. The semiconductor chip according to claim 4, wherein the metal layers with a large thermal expansion coefficient are formed by high-temperature evaporation, and the metal layers with a large thermal expansion coefficient are capable to produce a tensile stress effect after being cooled down to room temperature following the high-temperature evaporation.

6. The semiconductor chip according to claim 1, wherein the buffer electrode further comprises a metal adhesion layer and a conductive protective layer, the metal adhesion layer is formed on the chip body, the tensile stress layer is formed on the metal adhesion layer, and the conductive protective layer is formed on the tensile stress layer.

7. The semiconductor chip according to claim 6, wherein the conductive protective layer comprises at least one of platinum, gold, and titanium, with a thickness of 0.3-2 µm;
the metal adhesion layer comprises at least one of nickel, titanium, and chromium, with a thickness of 0.02-0.08 µm.

8. The semiconductor chip according to claim 7, wherein the metal adhesion layer comprises a chromium layer of 0.04 µm;
when the metal layers with a large thermal expansion coefficient are gold layers, the conductive protective layer comprises a platinum layer of 0.5 µm formed on the tensile stress layer and a titanium layer of 0.5 µm formed on the platinum layer of 0.5 µm;
when the metal layers with a large thermal expansion coefficient are aluminum layers, the conductive protective layer comprises a gold layer of 0.5 µm formed on the tensile stress layer and a platinum layer of 0.5 µm formed on the gold layer of 0.5 µm.

9. The semiconductor chip according to claim 1, wherein the external electrode comprises multiple metal layers stacked in sequence, each metal layer has a thickness of 0.05-2 µm, and the metal layers comprises at least two of aluminum, titanium, nickel, gold, platinum, and chromium.

10. The semiconductor chip according to claim 9, wherein the external electrode comprises a titanium layer of 0.1 µm, an aluminum layer of 0.2 µm, a titanium layer of 0.15 µm, an aluminum layer of 0.2 µm, a titanium layer of 0.15 µm, a nickel layer of 1.5 µm, and a gold layer of 0.15 µm stacked in sequence.

11. The semiconductor chip according to claim 1, wherein two buffer electrodes are spaced and arranged on a same side of the semiconductor chip.

12. The semiconductor chip according to claim 1, wherein both the buffer electrode and the external electrode are formed by evaporation.

13. The semiconductor chip according to claim 1, wherein the epitaxial layer is a GaN epitaxial layer, the chip body comprises the GaN epitaxial layer and an indium tin oxide layer stacked in sequence.

14. The semiconductor chip according to claim 13, wherein the GaN epitaxial layer comprises an N-GaN layer, an InGaN quantum well light-emitting layer, and a P-GaN layer.

15. A semiconductor wafer, comprising a substrate and several semiconductor chips configured on the substrate, each of the semiconductor chips being the semiconductor chip according to claim 1, and the chip body of the semiconductor chip being formed on the substrate.
